# FASCICULE DE BREVET EUROPEEN

(11) **EP 3 168 058 B1**
(45) Date de publication et mention de la délivrance du brevet: **07.10.2020**
(21) Numéro de dépôt: 16194755.1
(22) Date de dépôt: 20.10.2016
(51) Int. Cl.: B44F 7/00, C25D 1/00, G04B 45/00

(54) **PROCÉDÉ DE FABRICATION D'UNE PIÈCE MÉTALLIQUE AVEC AU MOINS UN MOTIF A ILLUSION D'OPTIQUE**
HERSTELLUNGSVERFAHREN EINES WERKSTÜCKS AUS METALL MIT MINDESTENS EINEM MOTIV MIT OPTISCHEN TÄUSCHUNGSELEMENTEN
METHOD FOR MANUFACTURING A METAL PART WITH AT LEAST ONE OPTICAL ILLUSION PATTERN

(30) Priorité: 11.11.2015 EP 15194158
(43) Date de publication de la demande: 17.05.2017
(73) Titulaire: Nivarox-FAR S.A., 2400 Le Locle (CH)
(72) Inventeur: Cusin, Pierre, 1423 Villars-Burquin (CH); Gandelhman, Alex, 2000 Neuchâtel (CH); Musy, Michel, 2552 Orpund (CH)
(74) Mandataire: Goulette, Ludivine

(56) Documents cités:
- EP-A1- 0 287 746
- EP-A1- 1 450 332
- EP-A1- 2 336 393
- WO-A2-2009/083487
- CH-A5- 694 466
- JP-A- S57 145 990
- JP-A- 2007 240 416
- US-A- 2 875 543
- US-A- 4 371 429
- US-A- 4 445 995
- US-A1- 2002 068 148
- US-B1- 8 314 989

## Description

### Domaine de l'invention

L'invention se rapporte à un procédé de fabrication d'une pièce d'habillage d'une pièce d'horlogerie à base de métal dont une face plane comporte au moins un motif à illusion d'optique et, plus précisément, au moins un motif faisant croire que la face plane ne l'est pas.

### Arrière-plan de l'invention

Il est connu de former des pièces d'habillage dont la surface supérieure est facettée et/ou chanfreinée afin d'améliorer l'esthétique d'une pièce d'horlogerie. Le document EP 1 557 729 divulgue notamment la très grande difficulté à développer un procédé de fabrication de pièces facettées ne nécessitant pas d'étape de retouche.

### Résumé de l'invention

Le but de la présente invention est de pallier tout ou partie les inconvénients cités précédemment en proposant un procédé de fabrication ne nécessitant ni facettage ni retouche pour obtenir une pièce simple à base de métal offrant l'illusion d'un facettage et/ou d'un chanfreinage.

A cet effet, l'invention se rapporte à un procédé de fabrication d'au moins une pièce pour former tout ou une partie d'un habillage d'une pièce d'horlogerie à base de métal avec au moins un motif à illusion d'optique caractérisé en ce qu'il comporte les étapes suivantes :
a) former un substrat dont la surface supérieure plane est électriquement conductrice et comporte des nervures négatives dudit au moins un motif à illusion d'optique de ladite au moins une pièce à fabriquer, lesdites nervures (5) formant au moins deux séries de segments parallèles, la première série de segments parallèles joignant la deuxième série de segments parallèles selon un angle compris entre 10 et 170 degrés afin d'offrir à ladite au moins une pièce l'illusion que ladite face plane comporte deux faces biseautées formant une arête ;
b) former un moule sur le substrat, le moule comportant au moins une cavité dont le fond est formé par ladite face supérieure du substrat ;
c) remplir ladite au moins une cavité du moule par galvanoplastie pour former ladite au moins une pièce à base de métal avec une face plane comportant ledit au moins un motif à illusion d'optique permettant de faire croire que ladite face n'est pas plane ;
d) libérer ladite au moins une pièce ainsi formée du substrat et du moule.

On comprend donc que le procédé de fabrication permet, grâce à la planéité du substrat, d'obtenir une pièce dont une face plane n'a plus besoin d'être *a posteriori* facettée ou, plus globalement, *a posteriori* retouchée.

De plus, le procédé de fabrication offre une très grande précision des cotes et très grande reproductibilité d'un même type de pièces monoblocs à base de métal, ou de plusieurs pièces monoblocs différentes à base de métal, sur un même substrat.

Enfin, la très grande précision et la très grande reproductibilité du procédé de fabrication permettent, avantageusement selon l'invention, d'obtenir une pièce très simple munie d'au moins un motif très fin et facilement reproductible faisant croire qu'une face plane ne l'est pas à la manière d'un usinage comme un biseautage ou un chanfreinage.

Conformément à d'autres variantes avantageuses
- les nervures forment au moins une série de segments courbes afin d'offrir à ladite au moins une pièce l'illusion que ladite face plane est bombée (cette mode de réalisation n'est pas pas couverte par l'invention revendiquée);
- les nervures forment au moins une série d'évidements distribués symétriquement les uns par rapport aux autres, ladite au moins une série d'évidements étant formée adjacente à une partie dont la surface supérieure du substrat ne comporte aucune nervure négative afin d'offrir à ladite au moins une pièce l'illusion que ladite face plane comporte deux faces biseautée formant une arête (cette mode de réalisation n'est pas pas couverte par l'invention revendiquée);
- les nervures sont distribuées à la périphérie de ladite au moins une cavité du moule et forment au moins deux séries de segments parallèles, les segments parallèles de la première série étant perpendiculaires aux segments parallèles de la deuxième série et se joignant selon un angle permettant d'offrir à ladite au moins une pièce l'illusion que ladite face plane est chanfreinée ;
- quel que soit le mode de réalisation, les nervures peuvent comporter une hauteur comprise entre 2 et 100 micromètres ;
- le procédé comporte en outre, entre l'étape c) et l'étape d), l'étape e) : usiner sélectivement une partie de ladite au moins une pièce à base de métal afin de former ladite au moins une pièce avec un moyen de fixation ;
- la surface supérieure du substrat est rendue électriquement conductrice par le dopage d'un substrat en silicium et/ou par le dépôt d'une couche électriquement conductrice sur un substrat en silicium ;
- le substrat comporte une épaisseur comprise entre 0,3 et 1 mm ;
- l'étape b) comporte les phases f) : déposer une couche de résine photosensible sur la surface supérieure électriquement conductrice du substrat, g) : illuminer sélectivement une partie de la résine photosensible et h) : développer la résine photosensible afin de former ladite au moins une cavité du moule ;
- ladite au moins une pièce est formée à base de nickel ou de nickel-phosphore ;
- plusieurs pièces sont formées sur le même substrat ;
- ladite au moins une pièce forme tout ou partie d'un cadran, d'une décoration de guichet, d'un réhaut, d'une lunette, d'un poussoir, d'une couronne, d'un fond de boîtier, d'une aiguille, d'un bracelet, d'un maillon, d'un fermoir, d'un décor, d'une masse oscillante ou d'une applique.

L'invention se rapporte également à l'habillage d'une pièce d'horlogerie comportant une pièce à base de métal obtenue à partir du procédé selon l'une des variantes précédentes, caractérisé en ce que la pièce comporte une face sensiblement plane avec au moins un motif à illusion d'optique faisant croire que ladite face plane ne l'est pas.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 5 sont des représentations schématiques d'étapes d'un procédé selon l'invention ;
- les figures 6 à 9 représentent des exemples d'aiguilles obtenues selon l'invention ;
- les figures 10 à 15 représentent des exemples d'heures index obtenus selon l'invention ;
- la figure 16 représente un exemple de décoration de guichet obtenu selon l'invention.

### Description détaillée des modes de réalisation préférés

La présente invention se rapporte à un procédé de fabrication d'une pièce monobloc de forme simple à base de métal offrant l'illusion d'un facettage et/ou d'un chanfreinage pour former tout ou partie de l'habillage d'une pièce d'horlogerie. A titre d'exemple nullement limitatif, la pièce peut ainsi former tout ou partie d'un cadran, d'une décoration de guichet, d'un réhaut, d'une lunette, d'un poussoir, d'une couronne, d'un fond de boîtier, d'une masse oscillante, d'une aiguille, d'un bracelet, d'un maillon, d'un fermoir, d'un décor ou d'une applique.

Bien entendu, une telle pièce ne saurait se limiter au domaine de l'horlogerie. A titre d'exemple nullement limitatif, une telle pièce pourrait alternativement former tout ou partie d'un article de bijouterie ou de joaillerie.

Le procédé est destiné à fabriquer au moins une pièce à base de métal. Le terme « à base de métal » signifie qu'un ou plusieurs métaux peuvent entrer dans la composition de la pièce. Ainsi, à titre d'exemple nullement limitatif, la (ou les) pièce(s) peut par exemple être formée à base de nickel ou de nickel-phosphore.

Avantageusement selon l'invention, chaque pièce à base de métal obtenue par le procédé comporte au moins un motif à illusion d'optique. Plus précisément, chaque pièce comporte, de manière avantageuse, une face sensiblement plane avec au moins un motif à illusion d'optique faisant croire que la face plane ne l'est pas ce qui permet d'avoir une pièce simple offrant, par exemple, l'illusion d'un facettage et/ou d'un chanfreinage.

Par soucis de simplification, les figures présentées montrent la fabrication d'une seule pièce sur un substrat. Toutefois, avantageusement selon l'invention, le procédé autorise plusieurs pièces identiques ou différentes à être formées sur le même substrat.

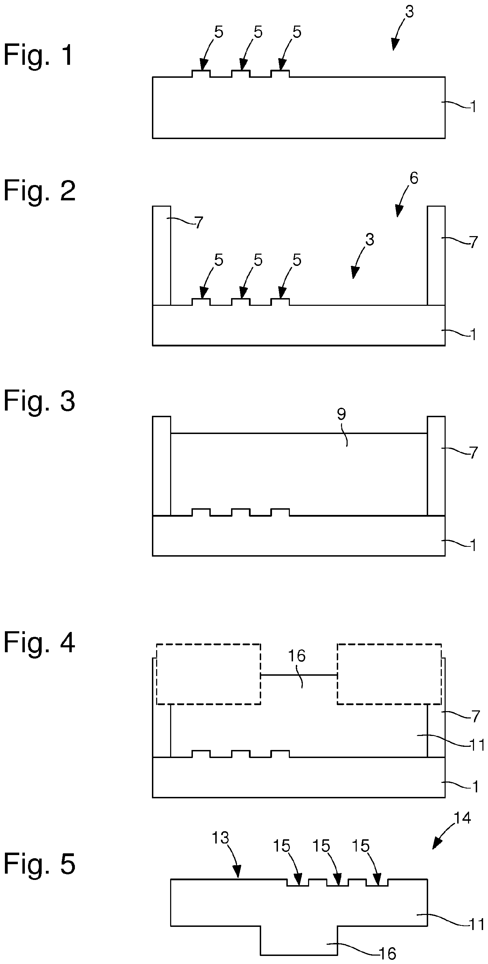

Comme visible à la figure 1, le procédé selon l'invention comporte une première étape a) destinée à former un substrat 1 dont la surface supérieure 3 plane est électriquement conductrice et comporte des nervures 5 négatives dudit au moins un motif à illusion d'optique de la pièce à fabriquer. La forme générale dudit au moins un motif à illusion d'optique sera mieux expliquée ci-dessous. Pour des raisons d'intelligibilité, les nervures 5 sont représentées schématiquement par trois plots en saillie de la surface supérieure 3 du substrat 1 à la figure 1.

Une grande variété de substrats 1 est possible. Préférentiellement, la matière du substrat 1 est choisie pour sa facilité à être rendue plane et sa très faible rugosité, c'est-à-dire son caractère naturel à présenter une surface lisse. A titre d'exemple, un substrat 1 à base de silicium possède ces deux avantages.

Dans le cas où le substrat 1 est en silicium, l'étape a) peut alors comporter une première phase destinée à revêtir le substrat 1 d'un masque présentant des ajourages laissant non recouverte une partie supérieure du substrat 1. Dans une deuxième phase, un gravage selon les ajourages du masque pourrait être effectué. Un tel gravage peut être réalisé par une attaque sèche ou humide. Enfin, dans une troisième phase illustrée à la figure 1, le masque est retiré pour ne laisser que les nervures 5 réalisées sur la surface supérieure 3 du substrat 1.

Dans le cas où le substrat 1 est en silicium, la surface supérieure 3 du substrat 1 peut être rendue électriquement conductrice par le dopage du silicium, c'est-à-dire en utilisant un substrat 1 déjà dopé avant son gravage ou en le dopant *a posteriori,* et/ou par le dépôt d'une couche électriquement conductrice.

De plus, le substrat 1 peut comporter une épaisseur comprise entre 0,3 et 1 mm alors que les nervures 5 peuvent s'étendre selon une hauteur comprise entre 2 et 100 micromètres à partir de la surface supérieure 3 du substrat 1.

Comme illustré à la figure 2, le procédé se poursuit avec une deuxième étape b) destinée à former un moule 7 sur le substrat 1. On comprend donc que le moule 7 comportant au moins une cavité 6 dont le fond est formé par la face supérieure 3 du substrat 1, c'est-à-dire, suivant la forme de la pièce souhaitée, une ou plusieurs cavités.

L'étape b) comporte préférentiellement les trois phases f) à h). L'étape b) comporte une première phase f) destinée à déposer une couche de résine photosensible sur la surface supérieure 3 électriquement conductrice du substrat 1. Une telle phase f) peut être obtenue par enduction centrifuge (également connue sous les termes anglais « spin coating ») ou par pulvérisation (également connue sous les termes anglais « spray coating »). La deuxième phase g) est destinée à illuminer sélectivement une partie de la résine photosensible. On comprend donc que suivant la nature de la résine photosensible, c'est-à-dire si la résine est du type positif ou négatif, l'illumination sera focalisée sur ladite future au moins une cavité 6 souhaitée ou sur les parties autres que ladite future au moins une cavité 6 souhaitée.

Enfin, l'étape b) se termine avec une troisième phase h) destinée à développer la résine photosensible sélectivement illuminée afin de former le moule 7, c'est-à-dire durcir la résine photosensible restant autour de ladite au moins une cavité 6 ou entre les cavités 6. Cette troisième phase h) est généralement obtenue par un traitement thermique destiné à durcir la résine suivi d'un développement destiné à former ladite au moins une cavité 6.

Comme illustré à la figure 3, le procédé continue avec une troisième étape c) destinée à remplir ladite au moins une cavité 6 du moule 7 par galvanoplastie pour former l'ébauche ou la pièce à base de métal avec une face plane comportant ledit au moins un motif 14 à illusion d'optique permettant de faire croire que ladite face n'est pas plane. Selon l'invention, la pièce à base de métal possède un même motif en projection. Toutefois, par la structuration du substrat 1, les nervures 5 vont former lors de l'étape c), des évidements 15 sur une face de l'ébauche ou de la pièce à base de métal. De plus, comme cela est expliqué ci-dessous, une étape optionnelle e) peut également être mise en œuvre après l'étape c).

Avantageusement selon l'invention, le procédé permet, grâce à l'étape b) très précise de photolithographie, d'obtenir un bloc 9 à base de métal avec des cotes externes et, éventuellement, internes d'une grande précision propre à respecter les tolérances très élevées d'une pièce dans le domaine de l'horlogerie. Par cotes internes, il faut comprendre, qu'à partir d'une éventuelle partie de résine 7 structurée qui est enclavée dans ladite au moins une cavité 6, un ajourage et/ou un trou dans la pièce à base de métal peut être directement formé lors de l'étape c).

Comme expliqué ci-dessus, le remplissage galvanique de chaque cavité 6 lors de l'étape c) peut, par exemple, être effectué avec un alliage formé de nickel et de phosphore (NiP) et notamment un tel alliage dont la proportion de phosphore est sensiblement égale à 12% (NiP12).

Enfin, le procédé se termine avec une quatrième et dernière étape d) destinée à libérer la pièce ainsi formée du substrat 1 et du moule 7. Par conséquent, dans l'exemple ci-dessus dans lequel le substrat 1 est en silicium, l'étape d) peut consister en une attaque sélective du silicium et une attaque sélective du matériau du moule 7. L'attaque du silicium peut, par exemple, être obtenue par une attaque chimique au moyen d'un bain comportant de l'hydroxyde de potassium (connu sous l'abréviation chimique KOH).

Selon une variante de l'invention illustrée aux figures 4 et 5, le procédé comporte en outre, entre l'étape c) et l'étape d), l'étape optionnelle e) destinée à usiner sélectivement une partie de la pièce à base de métal afin de former une pièce 11 avec au moins un moyen 16 de fixation.

Comme expliqué ci-dessus, le bloc 9 possédant un même motif en projection est alors modifié dans son épaisseur afin de former au moins un moyen 16 de fixation. On obtient ainsi la pièce 11 sans avoir à former plusieurs niveaux fonctionnels empilés ni à toucher à la face de la pièce comportant ledit au moins un motif 14 à illusion d'optique.

Du fait du positionnement précis de chaque bloc 9 sur le substrat 1, il est possible, lors de l'étape e), d'usiner chaque bloc 9 encore sur le substrat 1 avec un automate programmable selon des cotes précises. On remarque que, même si l'étape e) est destinée à usiner un ou plusieurs blocs 9, une partie de la résine 7 peut éventuellement être également usinée par les contraintes dues à l'encombrement des outils utilisés ou les volumes à enlever comme illustré par les dégagements visibles à la figure 4. Bien entendu, cette étape e) peut également permettre de former d'autres niveaux fonctionnels et/ou de mettre à niveau, par rodage, le moule 7 et le bloc 9.

On comprend alors, qu'en plus de la face 13 plane et des évidements 15 formant ledit au moins un motif 14 à illusion d'optique, la pièce 11 peut comporter en outre au moins un moyen 16 de fixation destiné à attacher la pièce 14 à base de métal. Le moyen 16 de fixation peut ainsi prendre la forme d'un pied ou d'un canon.

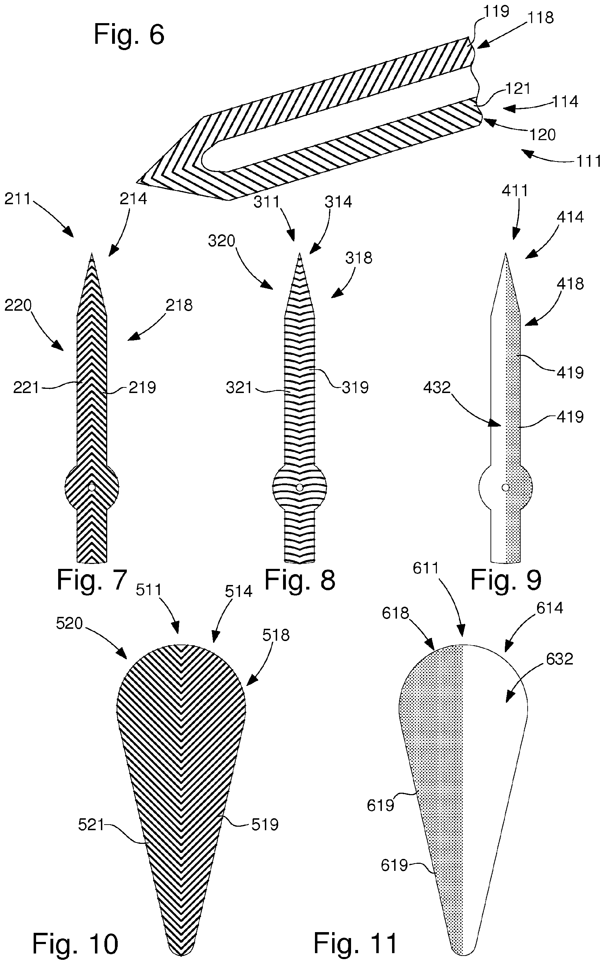

Les figures 6 à 16 représentent des exemples de pièces obtenues selon le procédé permettant de mieux expliquer un motif à illusion d'optique selon l'invention. A titre nullement limitatif, il est expliqué quatre modes de réalisation de motif à illusion d'optique.

Selon l'invention, le substrat 1 comporte des nervures permettant d'obtenir les exemples des figures 6, 7, 10 et 12. Le motif 114, 214, 514 et 714 à illusion d'optique des figures 6, 7, 10 et 12 forment ainsi au moins deux séries 118, 120, 218, 220, 518, 520, 718, 720 de segments 119, 121, 219, 221, 519, 521, 719, 721 parallèles, la première série 118, 218, 518, 718 de segments 119, 219, 519, 719 parallèles joignant la deuxième série 120, 220, 520, 720 de segments 121, 221, 521, 721 parallèles selon un angle compris entre 10 et 170 degrés afin d'offrir à la pièce 111, 211, 511, 711 l'illusion d'une face visible avec deux faces biseautées formant une arête alors qu'elle est plane.

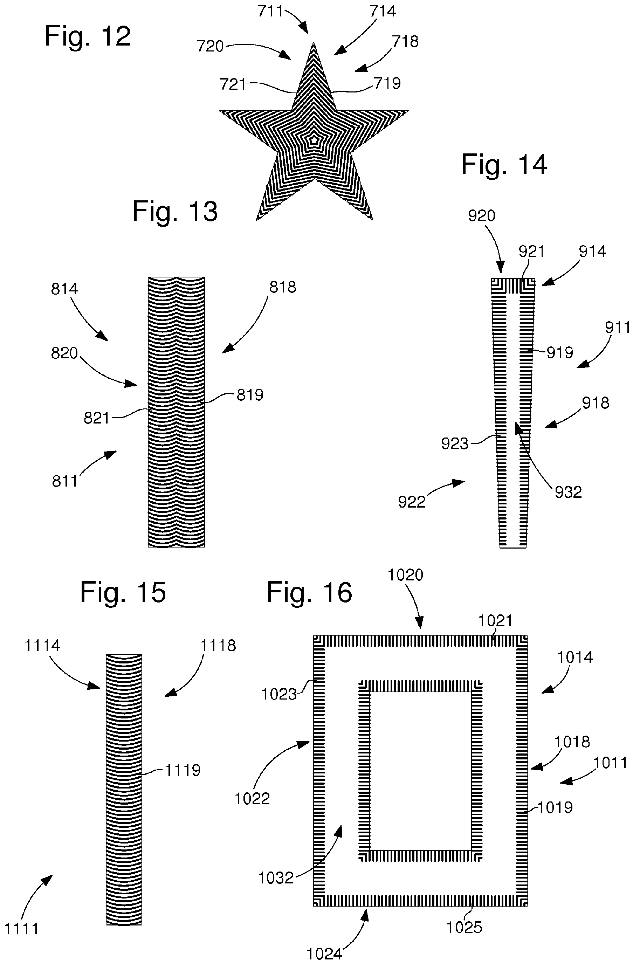

Selon un mode de réalisation, le substrat 1 comporte des nervures permettant d'obtenir les exemples des figures 8, 13 et 15. Le motif 314, 814 et 1114 à illusion d'optique des figures 8, 13 et 15 forment ainsi au moins une séries 318, 320, 818, 820, 1118 de segments 319, 321, 819, 821, 1119 courbes afin d'offrir à ladite pièce l'illusion d'une face visible bombée alors qu'elle est plane. Selon une variante du deuxième mode de réalisation visible aux figures 8 et 13, une première série 318, 818 de segments 319, 819 courbes joint une deuxième série 320, 820 de segments 321, 821 courbes selon un angle compris entre 10 et 170 degrés afin d'offrir à ladite pièce l'illusion d'une face visible avec deux faces bombées se rejoignant en formant une rainure alors que la face visible est plane.

Selon un autre mode de réalisation, le substrat 1 comporte des nervures en forme de plots permettant d'obtenir les exemples des figures 9 et 11. Le motif 414 et 614 à illusion d'optique des figures 9 et 11 forment ainsi au moins une série 418, 618 d'évidements 419, 619 distribués symétriquement les uns par rapport aux autres. Préférentiellement selon le troisième mode de réalisation, ladite au moins une série 418, 618 d'évidements étant formée adjacente à une partie 432, 632 dont la face de la pièce 411, 611 ne comporte aucun motif à illusion d'optique afin d'offrir à ladite pièce l'illusion d'une face visible avec deux faces biseautée formant une arête alors qu'elle est plane.

Comme visible aux figures 9 et 11, les évidements 419, 619 sont de section circulaire et régulièrement espacés entre eux. Bien entendu, la géométrie et la distribution des évidements 419, 619 peuvent différer suivant l'effet souhaité.

Selon un ultérieur mode de réalisation, le substrat 1 comporte des nervures qui sont distribuées à la périphérie des cavités du moule permettant d'obtenir les exemples des figures 14 et 16. Le motif 914 et 1014 à illusion d'optique des figures 14 et 16 forment ainsi au moins deux séries 918, 920, 922, 1018, 1020, 1022, 1024 de segments 919, 921, 923, 1019, 1021, 1023, 1025 parallèles, les segments 919, 923, 1019, 1023 parallèles de la première série 918, 922, 1018, 1022 étant perpendiculaires aux segments 921, 1021, 1025 parallèles de la deuxième série 920, 1020, 1024 et se joignant selon un angle à 90 degrés afin d'offrir à la pièce l'illusion d'une face visible chanfreinée entourant une partie 932, 1032 dont la face de la pièce 911, 1011 ne comporte aucun motif à illusion d'optique.

L'angle de 90 degrés est préférentiellement choisi car les faces externes des pièces 911, 1011 font un angle comparable à chaque coin. On comprend que cet angle de 90 degrés peut être plus grand ou plus petit suivant l'angle de chaque coin pour continuer à offrir l'illusion d'une face visible chanfreinée.

Bien entendu, la présente invention ne se limite pas à l'exemple illustré mais est susceptible de diverses variantes et modifications qui apparaîtront à l'homme de l'art. En particulier, les pièces 11, 111, 211, 311, 411, 511, 611, 711, 811, 911, 1011, 1111 pourrait faire l'objet d'une étape finale de durcissement comme par exemple divulgué dans le document EP 3 009 896 incorporé par référence à la présente demande.

Il est également envisageable que les nervures 5 puissent alternativement être formées par une photolithographie d'une résine photosensible sur la surface supérieure plane d'un substrat.

Dans une alternative particulière, le substrat 1 pourrait également être choisi afin de former des nervures 5 de géométrie différente de celle présentée aux figures 1 à 4. Ainsi, à titre d'exemple nullement limitatif, le substrat 1 pourrait être en silicium monocristallin orienté selon le plan (100) et subir un gravage humide à l'hydroxyde de potassium (KOH) permettant de former des gravures dont les flancs sont obliques et non verticaux comme illustré aux figures 1 à 4.

Enfin, les motifs à illusion d'optique ne sauraient se limiter à ceux décrits ci-dessus. Ainsi, d'autres modes de réalisation sont possibles sans sortir du cadre de l'invention. De plus, les quatre modes de réalisation présentés ci-dessus sont susceptibles d'être combinés entre eux, c'est-à-dire que plusieurs motifs différents peuvent apparaître sur la même pièce.

## Revendications

1. Procédé de fabrication d'au moins une pièce (11, 111, 211, 311, 411, 511, 611, 711, 811, 911, 1011, 1111) pour former tout ou partie de l'habillage d'une pièce d'horlogerie à base de métal avec au moins un motif (14, 114, 214, 314, 414, 514, 614, 714, 814, 914, 1014, 1114) à illusion d'optique **caractérisé en ce qu'**il comporte les étapes suivantes :
a) former un substrat (1) dont la surface (3) supérieure plane est électriquement conductrice et comporte des nervures (5) négatives dudit au moins un motif à illusion d'optique de ladite au moins une pièce à fabriquer, lesdites nervures (5) formant au moins deux séries de segments parallèles, la première série de segments parallèles joignant la deuxième série de segments parallèles selon un angle compris entre 10 et 170 degrés afin d'offrir à ladite au moins une pièce l'illusion que ladite face plane comporte deux faces biseautées formant une arête ;
b) former un moule (7) sur le substrat (1), le moule (7) comportant au moins une cavité (6) dont le fond est formé par ladite face supérieure du substrat (1) ;
c) remplir ladite au moins une cavité (6) du moule (7) par galvanoplastie pour former ladite au moins une pièce à base de métal avec une face plane comportant ledit au moins un motif à illusion d'optique permettant de faire croire que ladite face n'est pas plane ;
d) libérer ladite au moins une pièce (11, 111, 211, 311, 411, 511, 611, 711, 811, 911, 1011, 1111) ainsi formée du substrat (1) et du moule (7).

2. Procédé selon la revendication 1, **caractérisé en ce que** les nervures (5) forment au moins une série de segments courbes afin d'offrir à ladite au moins une pièce l'illusion que ladite face plane est bombée.

3. Procédé selon la revendication 1, **caractérisé en ce que** les nervures (5) forment au moins une série d'évidements distribués symétriquement les uns par rapport aux autres, ladite au moins une série d'évidements étant formée adjacente à une partie dont la surface supérieure du substrat ne comporte aucune nervure négative afin d'offrir à ladite au moins une pièce l'illusion que ladite face plane comporte deux faces biseautée formant une arête.

4. Procédé selon la revendication 1, **caractérisé en ce que** les nervures (5) sont distribuées à la périphérie de ladite au moins une cavité du moule et forment au moins deux séries de segments parallèles, les segments parallèles de la première série étant perpendiculaires aux segments parallèles de la deuxième série et se joignant selon un angle à 90 degrés afin d'offrir à ladite au moins une pièce l'illusion que ladite face plane est chanfreinée.

5. Procédé selon l'une des revendications précédentes, **caractérisé en ce que** les nervures (5) ont une hauteur comprise entre 2 et 100 micromètres.

6. Procédé selon l'une des revendications précédentes, **caractérisé en ce que** le procédé comporte en outre, entre l'étape c) et l'étape d), l'étape suivante :
e) usiner sélectivement une partie de ladite au moins une pièce (11, 111, 211, 311, 411, 511, 611, 711, 811, 911, 1011, 1111) à base de métal afin de former ladite au moins une pièce (11, 111, 211, 311, 411, 511, 611, 711, 811, 911, 1011, 1111) avec un moyen (16) de fixation.

7. Procédé selon l'une des revendications précédentes, **caractérisé en ce que** la surface (3) supérieure du substrat est rendue électriquement conductrice par le dopage d'un substrat en silicium et/ou par le dépôt d'une couche électriquement conductrice sur un substrat en silicium.

8. Procédé selon l'une des revendications précédentes, **caractérisé en ce que** le substrat (1) comporte une épaisseur comprise entre 0,3 et 1 mm.

9. Procédé (1) selon l'une des revendications précédentes, **caractérisé en ce que** l'étape b) comporte les phases suivantes :
f) déposer une couche de résine photosensible sur la surface supérieure électriquement conductrice du substrat ;
g) illuminer sélectivement une partie de la résine photosensible ;
h) développer la résine photosensible afin de former ladite au moins une cavité du moule.

10. Procédé selon l'une des revendications précédentes, **caractérisé en ce que** ladite au moins une pièce (11, 111, 211, 311, 411, 511, 611, 711, 811, 911, 1011, 1111) est formée à base de nickel ou de nickel-phosphore.

11. Procédé selon l'une des revendications précédentes, **caractérisé en ce que** plusieurs pièces sont formées sur le même substrat.

12. Procédé selon l'une des revendications précédentes, **caractérisé en ce que** ladite au moins une pièce (11, 111, 211, 311, 411, 511, 611, 711, 811, 911, 1011, 1111) forme tout ou partie d'un cadran, d'une décoration de guichet, d'un réhaut, d'une lunette, d'un poussoir, d'une couronne, d'un fond de boîtier, d'une aiguille, d'un bracelet, d'un maillon, d'un fermoir, d'un décor, d'une masse oscillante ou d'une applique.

13. Habillage d'une pièce d'horlogerie comportant une pièce (11, 111, 211, 311, 411, 511, 611, 711, 811, 911, 1011, 1111) à base de métal obtenue à partir du procédé selon l'une des revendications précédentes, **caractérisé en ce que** la pièce (11, 111, 211, 311, 411, 511, 611, 711, 811, 911, 1011, 1111) comporte une face (13) sensiblement plane avec au moins un motif (14, 114, 214, 314, 414, 514, 614, 714, 814, 914, 1014, 1114) à illusion d'optique faisant croire que ladite face (13) plane ne l'est pas.

## Patentansprüche

1. Verfahren zur Herstellung mindestens eines Teils (11, 111, 211, 311, 411, 511, 611, 711, 811, 911, 1011, 1111) zum Bilden einer ganzen oder teilweisen Ausstattung eines Uhrmachereiteils auf Metallbasis mit mindestens einem Motiv (14, 114, 214, 314, 414, 514, 614, 714, 814, 914, 1014, 1114) mit optischer Täuschung, **dadurch gekennzeichnet, dass** es folgende Schritte umfasst:
a) Bilden eines Substrats (1), dessen ebene, obere Oberfläche (3) elektrisch leitend ist und negative Rippen (5) des mindestens einen Motivs mit optischer Täuschung des mindestens einen herzustellenden Teils umfasst, wobei die Rippen (5) mindestens zwei Reihen von parallelen Segmenten bilden, wobei sich die erste Reihe von parallelen Segmenten an die zweite Reihe von parallelen Segmenten gemäß einem Winkel, der zwischen 10 und 170 Grad beträgt, anschließt, um dem mindestens einen Teil die Täuschung zu verleihen, dass die ebene Fläche zwei Schrägflächen umfasst, die eine Kante bilden;
b) Bilden einer Gießform (7) auf dem Substrat (1), wobei die Gießform (7) mindestens einen Hohlraum (6) umfasst, dessen Boden von der oberen Fläche des Substrats (1) gebildet wird;
c) Füllen des mindestens einen Hohlraums (6) der Gießform (7) mittels Galvanoplastik, um das mindestens eine Teil auf Metallbasis mit einer ebenen Fläche zu bilden, die das mindestens eine Motiv mit optischer Täuschung umfasst, welches glauben machen kann, dass die Fläche nicht eben ist;
d) Freilegen des mindestens einen Teils (11, 111, 211, 311, 411, 511, 611, 711, 811, 911, 1011, 1111), das so gebildet wurde, aus dem Substrat (1) und aus der Gießform (7).

2. Verfahren nach Anspruch 1, **dadurch gekennzeichnet, dass** die Rippen (5) mindestens eine Reihe von gekrümmten Segmenten bilden, um dem mindestens einen Teil die Täuschung zu verleihen, dass die ebene Fläche gewölbt ist.

3. Verfahren nach Anspruch 1, **dadurch gekennzeichnet, dass** die Rippen (5) mindestens eine Reihe von Aushöhlungen bilden, die symmetrisch zueinander verteilt sind, wobei die mindestens eine Reihe von Aushöhlungen angrenzend an einen Teil gebildet ist, dessen obere Oberfläche des Substrats keine negative Rippe umfasst, um dem mindestens einen Teil die Täuschung zu verleihen, dass die ebene Fläche zwei Schrägflächen umfasst, die eine Kante bilden.

4. Verfahren nach Anspruch 1, **dadurch gekennzeichnet, dass** die Rippen (5) an der Peripherie des mindestens einen Hohlraums der Gießform verteilt sind und mindestens zwei Reihen von parallelen Segmenten bilden, wobei die parallelen Segmente der ersten Reihe senkrecht zu den parallelen Segmenten der zweiten Reihe verlaufen und sich in einem 90 Grad-Winkel zusammenschließen, um dem mindestens einen Teil die Täuschung zu verleihen, dass die ebene Fläche abgeschrägt ist.

5. Verfahren nach einem der vorstehenden Ansprüche, **dadurch gekennzeichnet, dass** die Rippen (5) eine Höhe aufweisen, die zwischen 2 und 100 Mikrometer beträgt.

6. Verfahren nach einem der vorstehenden Ansprüche, **dadurch gekennzeichnet, dass** das Verfahren des Weiteren zwischen dem Schritt c) und dem Schritt d) den folgenden Schritt umfasst:
e) selektives Bearbeiten eines Teils des mindestens einen Teils (11, 111, 211, 311, 411, 511, 611, 711, 811, 911, 1011, 1111) auf Metallbasis, um das mindestens eine Teil (11, 111, 211, 311, 411, 511, 611, 711, 811, 911, 1011, 1111) mit einem Befestigungsmittel (16) zu bilden.

7. Verfahren nach einem der vorstehenden Ansprüche, **dadurch gekennzeichnet, dass** die obere Oberfläche (3) des Substrats mittels Dotierung eines Siliziumsubstrats und/oder mittels Beschichtung mit einer elektrisch leitenden Schicht auf einem Siliziumsubstrat elektrisch leitend gemacht wird.

8. Verfahren nach einem der vorstehenden Ansprüche, **dadurch gekennzeichnet, dass** das Substrat (1) eine Dicke umfasst, die zwischen 0,3 und 1 mm beträgt.

9. Verfahren (1) nach einem der vorstehenden Ansprüche, **dadurch gekennzeichnet, dass** der Schritt b) folgende Phasen umfasst:
f) Beschichten mit einer Schicht aus lichtempfindlichem Harz auf der elektrisch leitenden, oberen Oberfläche des Substrats;
g) selektives Beleuchten eines Teils des lichtempfindlichen Harzes;
h) Entwickeln des lichtempfindlichen Harzes, um den mindestens einen Hohlraum der Gießform zu bilden.

10. Verfahren nach einem der vorstehenden Ansprüche, **dadurch gekennzeichnet, dass** das mindestens eine Teil (11, 111, 211, 311, 411, 511, 611, 711, 811, 911, 1011, 1111) auf Basis von Nickel oder von Nickel-Phosphor gebildet wird.

11. Verfahren nach einem der vorstehenden Ansprüche, **dadurch gekennzeichnet, dass** mehrere Teile auf demselben Substrat gebildet werden.

12. Verfahren nach einem der vorstehenden Ansprüche, **dadurch gekennzeichnet, dass** das mindestens eine Teil (11, 111, 211, 311, 411, 511, 611, 711, 811, 911, 1011, 1111) ein Zifferblatt, eine Verzierung eines Fensterchens, einen Höhenring, eine Lünette, einen Drücker, eine Krone, einen Boden einer Schale, einen Zeiger, ein Armband, ein Kettenglied, eine Schließe, eine Ausschmückung, eine schwingende Masse oder eine Applike ganz oder teilweise bildet.

13. Ausstattung eines Uhrmachereiteils, umfassend ein Teil (11, 111, 211, 311, 411, 511, 611, 711, 811, 911, 1011, 1111) auf Metallbasis, das ausgehend von dem Verfahren nach einem der vorstehenden Ansprüche erhalten wird, **dadurch gekennzeichnet, dass** das Teil (11, 111, 211, 311, 411, 511, 611, 711, 811, 911, 1011, 1111) eine im Wesentlichen ebene Fläche (13) mit mindestens einem Motiv (14, 114, 214, 314, 414, 514, 614, 714, 814, 914, 1014, 1114) mit optischer Täuschung umfasst, welches glauben macht, dass die ebene Fläche (13) dies nicht ist.

## Claims

1. Method for fabrication of at least one component (11, 111, 211, 311, 411, 511, 611, 711, 811, 911, 1011, 1111) to form all or part of the exterior part of a metal-based timepiece with at least one optical illusion pattern (14, 114, 214, 314, 414, 514, 614, 714, 814, 914, 1014, 1114), **characterized in that** the method comprises the following steps:
a) forming a substrate (1) whose flat upper surface (3) is electrically conductive and comprises negative ribs (5) of said at least one optical illusion pattern of said at least one component to be fabricated, said ribs (5) forming at least two series of parallel segments, the first series of parallel segments joining the second series of parallel segments at an angle comprised between 10 and 170 degrees, such that said at least one component gives the illusion that said flat surface comprises two bevelled surfaces forming an edge;
b) forming a mould (7) on the substrate (1), the mould (7) comprising at least one cavity (6) whose base is formed by said upper surface of the substrate (1);
c) filling said at least one cavity (6) of the mould (7) by electrodeposition to form said at least one metal-based component with a flat surface comprising said at least one optical illusion pattern making said surface appear to not be flat;
d) releasing said at least one component (11, 111, 211, 311, 411, 511, 611, 711, 811, 911, 1011, 1111) thereby formed from the substrate (1) and from the mould (7).

2. Method according to claim 1, **characterized in that** the ribs (5) form at least one series of curved segments such that said at least one component gives the illusion that said flat surface is domed.

3. Method according to claim 1, **characterized in that** the ribs (5) form at least one series of recesses arranged symmetrically in relation to each other, said at least one series of recesses being formed adjacent to a portion wherein the upper surface of the substrate has no negative rib such that said at least one component gives the illusion that said flat surface comprises two bevelled surfaces forming an edge.

4. Method according to claim 1, **characterized in that** the ribs (5) are arranged at the periphery of said at least one mould cavity and form at least two series of parallel segments, the parallel segments of the first series being perpendicular to the parallel segments of the second series and joining at an angle of 90 degrees such that said at least one component gives the illusion that said flat surface is chamfered.

5. Method according to any of the preceding claims, **characterized in that** the height of the ribs (5) is comprised between 2 and 100 micrometres.

6. Method according to any of the preceding claims, **characterized in that** between step c) and step d), the method further comprises the following step:
e) selectively machining one portion of said at least one metal-based component (11, 111, 211, 311, 411, 511, 611, 711, 811, 911, 1011, 1111) to form said at least one component (11, 111, 211, 311, 411, 511, 611, 711, 811, 911, 1011, 1111) with a securing means (16).

7. Method according to any of the preceding claims, **characterized in that** the upper surface (3) of the substrate is rendered electrically conductive by doping a silicon substrate and/or by the deposition of an electrically conductive layer on a silicon substrate.

8. Method according to any of the preceding claims, **characterized in that** the substrate (1) has a thickness comprised between 0.3 and 1 mm.

9. Method (1) according to any of the preceding claims, **characterized in that** step b) comprises the following phases:
f) depositing a layer of photosensitive resin on the electrically conductive upper surface of the substrate;
g) selectively illuminating one portion of the photosensitive resin;
h) developing the photosensitive resin to form said at least one cavity of the mould.

10. Method according to any of the preceding claims, **characterized in that** said at least one component (11, 111, 211, 311, 411, 511, 611, 711, 811, 911, 1011, 1111) is formed from a nickel or nickel-phosphorus base.

11. Method according to any of the preceding claims, **characterized in that** several components are formed on the same substrate.

12. Method according to any of the preceding claims, **characterized in that** said at least one component (11, 111, 211, 311, 411, 511, 611, 711, 811, 911, 1011, 1111) forms all or part of a dial, an aperture decoration, a flange, a bezel, a push-piece, a crown, a case back cover, a hand, a bracelet or strap, a link, a clasp, a decoration, an oscillating weight or an applique.

13. Exterior part of a timepiece comprising a metal-based component (11, 111, 211, 311, 411, 511, 611, 711, 811, 911, 1011, 1111) obtained by the method according to any of the preceding claims, **characterized in that** the component (11, 111, 211, 311, 411, 511, 611, 711, 811, 911, 1011, 1111) has a substantially flat surface (13) with at least one optical illusion pattern (14, 114, 214, 314, 414, 514, 614, 714, 814, 914, 1014, 1114) making said flat surface (13) appear to not be flat
